# EUROPEAN PATENT APPLICATION

(11) **EP 1 455 564 A1**
(43) Date of publication of application: **08.09.2004**
(21) Application number: 03388014.7
(22) Date of filing: 05.03.2003
(51) Int. Cl.: H05K 9/00

(54) **Electronic device provided with an EMI shield**

(71) Applicant: Sony Ericsson Mobile Communications AB, 221 88 Lund (SE)
(72) Inventor: Fagrenius, Gustav, 224 68 Lund (SE)
(74) Representative: Andersen, Poul Hoeg

(57) **Abstract**

An electronic device (3) comprising a printed circuit board (PCB) (1) with an outer rim (4) and a electromagnetic interference (EMI) shield (2) that spans across the PCB (1) and is electrically connected to the outer rim (4) of the PCB (1). The electrical connection between the PCB (1) and the EMI shield (2) is achieved by means of an electrically conductive elastomeric material (5) that extends radially from the rim (4) of the PCB (1) and abuts on a side wall (6) of the EMI shield (2).

## Description

### Technical field

The invention relates to an electronic device comprising a printed circuit board (PCB) with an outer rim and an electromagnetic interference (EMI) shield that spans across the PCB and is electrically connected to the outer rim of the PCB.

### Related prior art

US-A-5 250 751 discloses a gasket for an electromagnetic interference (EMI) shield. The gasket is attached to an end portion of a board member and comprises a flat base portion with a width substantially equal to the thickness of the board member. The gasket also comprises a plurality of pairs of resiliently fingers arranged in an extending direction from the flat base portion. Some of the resiliently fingers are bent downwardly toward one another, forming carrier strips for holding side walls of the board member therebetween. Other fingers may be bent upwardly, forming resilient tabs for contacting the desired portion of another element. In one embodiment a metallic mesh material provided with an elastomeric core material is held between the upwardly extending tabs.

### Object of the invention

Conventionally, an EMI shield is provided with a flange that abuts on the top surface or the bottom surface of the PCB via a gasket provided between the PCB and the EMI shield. The force compressing the gasket may unintentionally bend the PCB which may damage the soldering between components and the PCB or the component itself.

By arranging the EMI gasket as described above it is possible to avoid this pressure from the EMI shield on the top or on the bottom of the PCB. By providing the gasket at the rim of the PCB, the pressure from the EMI shield is transferred radially to the PCB and the PCB can absorb the force without bending.

However, the degree of freedom in relation to using a specific gasket disclosed in US-A-5 250 751 to different applications is rather limited. This is due to the fact that in a first embodiment the resilient tabs have a certain length that determines the maximum distance between the PCB and the wall of the shield. In a second embodiment employing a metallic mesh with an elastomeric core material, the distance can be varied in accordance with the diameter and flexibility of the metallic mesh and the elastomeric core material.

Thus, the structure of the gasket must be chosen in each case depending of the distance between the rim of the PCB and the wall of the shield.

It is an object of the present invention to provide an electronic device provided with an EMI gasket with an extension that can be easily varied in dependency of the actual situation.

### Summary of the invention

The object of the invention is achieved by arranging the electronic device mentioned in the opening paragraph in such manner that the electrical connection between the PCB and the EMI shield is achieved by means of an electrically conductive elastomeric material that extends radially from the rim of the PCB and abuts on a side wall of the EMI shield.

Thereby is obtained that the radial extent of the EMI gasket, i.e. the radial extent of the electrically conductive elastomeric material from the rim of the PCB, can be easily varied by simply applying more or less material to the rim of the PCB. This means that if, in a certain application the distance between the rim of the PCB and the side wall of the EMI shield is increased, a larger amount of electrically conductive elastomeric material is applied to the rim of the PCB. Likewise, if the distance between the rim of the PCB and the side wall of the EMI shield is decreased, a smaller amount of electrically conductive elastomeric material is applied to the rim of the PCB.

In a first embodiment the electrically conductive elastomeric material is provided directly on the outer rim of the PCB. This is the most simple case, since it does not require any extra components.

However, if it is desirable not to apply the electrically conductive elastomeric material directly to the rim of the PCB it can in another embodiment be provided on a rail that is secured to the rim of the PCB. Such rails with electrically conductive elastomeric material are made in advance of the assembly of the electronic device and simple mechanical means can be used for assembling the EMI shield with the PCB.

In a preferred embodiment the rail comprises an elongate centre part provided with flanges that are mechanically connected to an upper face and a lower face, respectively, of the PCB, while the electrically conductive elastomeric material is provided on the centre part. By this configuration of the rail it is possible to obtain a firm electrical as well as mechanical contact between the PCB and the rail.

In order to ensure better mechanical and possibly electrical contact between the PCB and the rail, one of the flanges can be provided with barbs.

Preferably, the centre part of the rail is provided with at least one opening through which the electrically conductive elastomeric material extends. Thereby the electrically conductive elastomeric material will embed the centre part of the rail, when it is applied thereto, which further ensures a firm connection between the rail and the electrically conductive elastomeric material.

The electrically conductive elastomeric material can be chosen in accordance with specific demands, but preferably it is a silicone material, which has proven to be suitable for the purpose.

In a preferred embodiment, the electronic device is a mobile communications device, such as a mobile telephone.

It shall be emphasised that the term "comprise/comprising" when used in this specification is taken to specify the presence of stated features, integers, steps or components, but does not preclude the presence or addition of one or more other features, integers, steps, components or groups thereof.

### Description of the drawings

The invention will be described in detail in the following with reference to the drawings in which
Fig. 1 shows a cross-section of PCB provided with an EMI shield according to a first embodiment of the invention;
Fig. 2 shows in an enlarged view the rim of the PCB shown in Fig. 1;
Fig. 3 shows a cross-section of PCB provided with an EMI shield according to a second embodiment of the invention;
Fig. 4 shows in an enlarged view the rim of the PCB shown in Fig. 3; and
Fig. 5 shows a clip used in the embodiment shown in Figs 3 and 4.

### Detailed description of embodiments of the invention

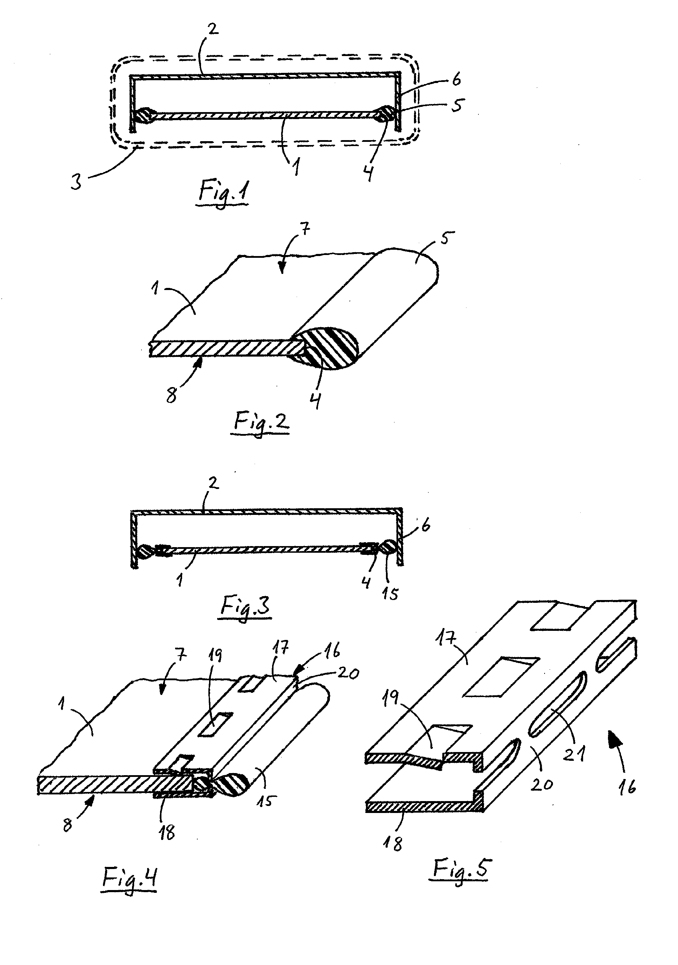

Fig. 1 shows a cross-section of a PCB 1 provided with an EMI shield 2 according to a first embodiment of the invention. The PCB 1 may be of any known type and is shown without any electronic components on its upper and lower faces. Of course, when the PCB 1 is a part of an electronic device 3 indicated with broken lines, it will be provided with electronic components as it is commonly known in the art. Since this is not a part of the present invention no further comments as to which kind of components will be made herein. Likewise, no components will be shown in the drawings.

In order to achieve a shielding effect, the PCB 1 and the EMI shield 2 must be electrically interconnected. Conventionally this is achieved by soldering or otherwise connecting the rim of the EMI shield to the top or bottom surface of the PCB. However, this has the disadvantage that bending forces may be applied to the PCB which may damage the soldering between the PCB and the electronic components or the components themselves as described above.

In accordance with the invention, the rim 4 of PCB 1 is provided with an electrically conductive elastomeric material 5 that extends radially from the rim 4 of the PCB 1, i.e. it extends outwardly in substantially the same plane as the PCB 1. The electrically conductive elastomeric material 5, which may be a silicone material, abuts on the side wall 6 of the EMI shield and thereby electrically interconnects the PCB 1 and the EMI shield 2.

Fig. 2 shows in an enlarged view the rim 4 of the PCB 1 shown in Fig. 1 before the EMI shield 2 is added. It is clearly shown how the electrically conductive elastomeric material 5 is supplied to the rim 4 of the PCB 1 in such manner that it spans across the rim 4 and is secured to the upper face 7 as well as to the lower face 8 of the PCB 1 in order to ensure a firm mechanical and electrical connection between the electrically conductive elastomeric material 5 and the PCB 1.

The electrically conductive elastomeric material 5 is applied to the rim 4 of the PCB 1 in a way and in an amount that ensures that the radial extent thereof is slightly larger than the distance between the rim 4 of the PCB 1 and the side wall 6 of the EMI shield 2. Thereby is ensured that the electrically conductive elastomeric material 5 will be slightly compressed when the EMI shield 2 is added such that a firm electrical contact between the EMI shield 2 and the electrically conductive elastomeric material 5 is obtained.

The amount and radial extent of electrically conductive elastomeric material 5 can easily be adjusted to a specific application. If e.g. the distance between the rim 4 of the PCB 1 and the side wall 6 of the EMI shield 2 is increased the electrically conductive elastomeric material 5 is applied to the rim 4 of the PCB 1 in such manner that the radial extension thereof is increased, e.g. by applying a larger amount of electrically conductive elastomeric material 5. Similarly, if the distance between the rim 4 of the PCB 1 and the side wall 6 of the EMI shield 2 is decreased the electrically conductive elastomeric material 5 is applied to the rim 4 of the PCB 1 in such manner that the radial extension thereof is decreased, e.g. by applying a smaller amount of electrically conductive elastomeric material 5.

In the embodiment shown in Figs 1 and 2 the electrically conductive elastomeric material 5 is applied directly to the rim 4 of the PCB 1. This means that the PCB 1 must be processed through an apparatus that applies the electrically conductive elastomeric material 5 directly to the rim of the PCB 1.

It is, however, possible to provide the rim 4 of the PCB 1 with an electrically conductive elastomeric material 5 without having to apply it directly to the rim 4 of the PCB 1. An example of this is shown in Figs 3-5 that will be described in the following. It should be noted that the same reference numerals will be used for the same parts as those in Figs 1-2.

Fig. 3 shows a cross-section of PCB 1 provided with an EMI shield 2 according to a second embodiment of the invention. Again, the PCB 1 may be of any known type and is shown without any electronic components on its upper and lower faces. Of course, in practice the PCB 1 will be provided with electronic components as it is commonly known in the art.

Also in this embodiment the rim 4 of the PCB 1 is provided with an electrically conductive elastomeric material 15 that extends radially from the rim 4 of the PCB 1. The electrically conductive elastomeric material 15 abuts on the side wall 6 of the EMI shield 2 and thereby electrically interconnects the PCB 1 and the EMI shield 2.

Contrary to the first embodiment shown in Figs 1-2, the electrically conductive elastomeric material 15 is in this second embodiment not applied directly to the rim 4 of the PCB 1, but is applied to a rail 16 with means for securing the rail 16 with the electrically conductive elastomeric material 15 to the rim 4 of the PCB 1.

Fig. 4 shows in an enlarged view of the rim 4 of the PCB 1 shown in Fig. 3 before the EMI shield 2 is added. It is clearly shown how the electrically conductive elastomeric material 15 is applied to the rail 16 that in turn is secured to the rim 4 of the PCB 1 by gripping the upper face 7 as well as to the lower face 8 of the PCB 1 via an upper flange 17 and a lower flange 18. In order to ensure a firm mechanical connection between the rail and the PCB 1 the upper flange 17 is provided with downwardly bended parts that form barbs 19 that, once the rail 16 has been mounted on the PCB 1, prevent, or at least make it difficult, to remove the rail 16 again.

The electrically conductive elastomeric material 15 is applied to the centre part 20 of the rail 16 in such manner that it extends through a plurality of openings 21 (see Fig. 5) whereby firm mechanical connection between the rail 16 and the electrically conductive elastomeric material 15 is obtained by embedding the rail in the electrically conductive elastomeric material 15. Again, the amount of electrically conductive elastomeric material 15 is adjusted to the distance between the rim 4 of the PCB 1 and the side wall 6 of the EMI shield 2, such that is ensured that the electrically conductive elastomeric material 5 will be slightly compressed when the EMI shield 2 is added.

The electrical contact between the PCB 1 and the electrically conductive elastomeric material 15 may be achieved by forcing the electrically conductive elastomeric material 15 towards the rim 4 of the PCB 1 if the rim 4 as such is provided with appropriate electrically conductive areas. Alternatively, the electrical contact may be achieved via the rail 16 if the rail is made of an electrically conductive material, such as steel, nickel, cupper, etc. The electrical contact between the rail 16 and the PCB 1 may be provided through the barbs 19 that surely are in intimate contact with the PCB 1.

The rail may, of course, be shaped differently from the one shown in Fig. 5 and may even be substituted by shorter clips that are secured to a strip of electrically conductive elastomeric material in regular intervals.

Other modifications of the attachment means between the rim 4 of the PCB 1 and the electrically conductive elastomeric material15 may be provided within the scope of the invention as claimed in the appended claims.

## Claims

1. An electronic device (3) comprising a printed circuit board (PCB) (1) with an outer rim (4) and a electromagnetic interference (EMI) shield (2) that spans across the PCB (1) and is electrically connected to the outer rim (4) of the PCB (1), **characterised in that** the electrical connection between the PCB (1) and the EMI shield (2) is achieved by means of an electrically conductive elastomeric material (5;15) that extends radially from the rim (4) of the PCB (1) and abuts on a side wall (6) of the EMI shield (2).

2. An electronic device according to claim 1, **characterised in that** the electrically conductive elastomeric material (5) is provided directly on the outer rim (4) of the PCB (1).

3. An electronic device according to claim 1, **characterised in that** the electrically conductive elastomeric material (15) is provided on a rail (16) that is secured to the rim (4) of the PCB (1).

4. An electronic device according to claim 3, **characterised in that** the rail (16) comprises an elongate centre part (20) provided with flanges (17,18) that are mechanically connected to an upper face (7) and a lower face (8), respectively, of the PCB (1); the electrically conductive elastomeric material (15) being provided on the centre part (20).

5. An electronic device according to claim 4, **characterised in that** one of the flanges (17) is provided with barbs (19).

6. An electronic device according to claim 4 or 5, **characterised in that** the centre part (20) is provided with at least one opening (21) through which the electrically conductive elastomeric material (15) extends.

7. An electronic device according to any one of claims 1-6, **characterised in that** the electrically conductive elastomeric material (5;15) is a silicone material.

8. An electronic device according to any one of claims 1-7, **characterised in that** the electronic device (3) is a mobile communications device, such as a mobile telephone.
